# EUROPÄISCHE PATENTSCHRIFT

(11) **EP 2 790 232 B1**
(45) Veröffentlichungstag und Bekanntmachung des Hinweises auf die Patenterteilung: **19.06.2019**
(21) Anmeldenummer: 14401042.8
(22) Anmeldetag: 09.04.2014
(51) Int. Cl.: H02S 20/00, H02S 30/10, H01L 31/048

(54) **Glas-Glas-Solarmodul-Laminat mit Solarzellen**
Glass-glass solar module laminate with solar cells
Module solaire en laminé de verre avec cellules solaires

(30) Priorität: 12.04.2013 DE 102013006284
(43) Veröffentlichungstag der Anmeldung: 15.10.2014
(73) Patentinhaber: SOLARWATT GmbH, 01109 Dresden (DE)
(72) Erfinder: Uhlmann, Rüdiger, 01109 Dresden (DE); Prause, Silvio, 01159 Dresden (DE); Friedrich, Steffen, 01474 Radeberg (DE); Wald, Dietmar, 01189 Dresden (DE); Henze, Stefan, 01187 Dresden (DE); Schumann, Peter, 01159 Dresden (DE)
(74) Vertreter: Kruspig, Volkmar

(56) Entgegenhaltungen:
- EP-A1- 2 423 971
- US-A1- 2010 212 725
- US-A1- 2011 226 335
- US-A1- 2012 118 360

## Beschreibung

Die Erfindung betrifft ein Glas-Glas-Solarmodul-Laminat mit innen liegenden Solarzellen mit Rahmen.

Mittlerweile wird eine Lebensdauergarantie von bis zu 25 Jahren für installierte Solarmodule gefordert. Am ehesten kann diese lange Lebensdauer mit Glas-Glas-Solarmodulen garantiert werden. Bei sogenannten Doppelglas-Laminaten sind die aktiven untereinander verschalteten Solarzellen und die Stromführungsbahnen in der Regel in einem Einbettungsmaterial zwischen zwei parallel angeordneten und miteinander dicht laminierten Glasscheiben angeordnet. Das Einbettungsmaterial verbindet zum einen die beiden als Schutz dienenden Glasscheiben untereinander und enthält zum Anderen die aktiven Solarzellen mit den Kontaktierungs- und Stromsammelelektroden und deren Anschlussfahnen nach außen. Aus Festigkeitsgründen und auf Grund der thermischen Belastung werden hier Solarmodule mit zwei Glasscheiben mit Dicken oberhalb von 3 mm Glasdicke bei den üblichen Einsatzbedingungen zwischen minus 40° C und plus 90° C betrieben. Da ein solches Solarmodul aus einem Doppelglas-Laminat flächenmäßig mittlerweile erheblich größer als 1 Quadratmeter ausgeführt ist, ist es erforderlich die Glasscheiben entsprechend dick auszuführen um die auf ein Solarmodul wirkenden möglichen Flächenlasten in jedem Fall aufnehmen zu können. Dieses nicht unwesentliche Sicherheitserfordernis wirkt einer weiteren Verringerung der Glasdicke und damit hauptsächlich auch dem Gewicht eines Glas-Glas-Solarmoduls direkt entgegen. Zudem hat es sich gezeigt, dass sich bei Doppelglas-Laminaten mit zwei Glasscheiben mit Glasdicken unterhalb von 3 mm bei Temperaturen vor allem im oberen Einsatztemperaturbereich ihre Biegesteifigkeit erheblich verringern kann. Bei hohen Einsatztemperaturen wird das Einbettungsmaterial oftmals so weich, dass die beiden verbundenen Glasscheiben bereits unter Schwerkrafteinfluss beginnen sich durchzubiegen. Je dünner das Glas der beiden Einzelscheiben gewählt wird, umso mehr biegt sich solch ein Glas-Glas-Solarmodul-Laminat letztlich durch. Unter dem Eigengewicht des Doppelglas-Laminats (Gewicht der beiden Glasscheiben, der Solarzellen, der Verbindungselemente und des Einbettungsmaterials) kommt es zu einem in der Regel sogar sichtbaren Durchhängen des Doppelglas-Laminats gegenüber einem außen herum angeordneten Modulrahmen oder anderen tragenden Modulelementen. Dieser vor allem durch höhere Temperaturen eingetretener Durchhang bleibt während und nach Abkühlung, zum Beispiel in der Nacht, weitgehend erhalten. Vor allem bei sehr großen Doppelglas-Laminaten, weit größer als ein Quadratmeter ergibt sich bei zu großem Durchhang, d. h. bei einem Durchhanglimit von drei Millimeter und darüber, ein unschöner Anblick.

Bei Glas-Folie-Solarmodul-Laminaten, welche im Gegensatz zu den Glas-Glas-Laminaten, eine flächenmäßig deutlich geringere Tragfähigkeit besitzen, werden zur Verstärkung in der Regel Rahmen aus Aluminium-Strangpressprofilen angeordnet. Es sind auch andere technische Lösungen beschrieben, bei denen zur Verstärkung der PV-Module rückseitig ein an- bzw. aufgeklebtes Trapezblech angeordnet ist, wie aus der DE 36 11 543 AI bekannt.

Vollflächige Verstärkungen könnten auch dort angewandt werden, wo aus Gründen einer wenig geneigten Anordnung vieler nebeneinander angeordneter Solarmodule, d. h. wenn diese in engem dichtem Verbund verlegt sind, ein Betreten von Personen vorteilhaft wäre. Dies könnte bereits zum Teil bei der Montage oder bei der Kontrolle der einzelnen Module oder der darunter liegenden Konstruktion oder des sich darunter befindlichen Daches sinnvolle Effekte mit sich bringen. Ein solches Betreten von Solarmodulen ist gegenwärtig nicht zulässig, da der von einer Person ausgeübte Druck zu einer starken Durchbiegung des Solarmodul-Laminats und damit zu Beschädigungen am bzw. im Glas, der innen liegenden Solarzellen und der verschiedenen elektrischen Verbindungen führt.

Die bisherige Art der Rahmung, in der Regel nur außen am Rand der Solarmodule, steht dem Trend zu immer größeren, weil kosteneffizienteren PV-Modulen entgegen.

Das Gebrauchsmuster DE 202 15 462 U1 beschreibt ein großes Rahmenformteil mit Stützelementen für die Aufnahme eines photovoltaischen Solarmoduls. Die hier angeordnete flächige Verstärkung wirkt sich positiv auf die Tragfähigkeit aus. Ein überstehender Rahmen ist nicht ausgebildet. Eine Montage ist aber nur aufklebfähigen Untergründen möglich, was einer Verwendung als Standard-Solarmodul für alle möglichen Einsatzfälle entgegensteht.

In einer weiteren Offenlegungsschrift, der DE 40 14 200 AI ist unter anderem das werksseitige Ankleben von Befestigungsprofilen, auf die Rückseite eines photovoltaischen Solarmoduls in dessen Randbereich beschrieben worden. Diese konstruktiv besonders gestalteten Befestigungsprofile aus der DE 40 14 200 AI dienen dem Anschrauben an ein zusätzliches Gestellsystem. Dabei ist die Randausbildung dieses Befestigungsprofils so massiv ausgeführt, dass allein daran die Befestigung des Solarmoduls mit der Unterkonstruktion erfolgt. Gleichzeitig werden über diese Befestigungsprofile die Flächenlasten mit aufgenommen und in die Unterkonstruktion abgeführt.

In der Druckschrift DE 10 2011 056 875 A1 ist ein mit einem besonderen Rahmen ausgebildetes Solarmodul beschrieben, bei dem der Rahmen ohne jegliche Verwendung von Schrauben zusammengefügt werden kann. Die Umfangsrahmenkomponenten werden durch Verriegelungselemente und eine oder mehrere quer zwischen den beiden Seitenschienen angeordnete Rippen untereinander verbunden. Die Rippen haben hier eine reine Versteifungsfunktion um den Rahmen schraubenlos zusammen fügen zu können. Die Seitenschienen des Rahmens sind dabei mit einer oder mehreren Rippen mittels geeigneter spezieller Befestigungsmittel verbunden. Diese technische Lösung ist auf eine besonders kostengünstige Konstruktion und Montage eines Rahmens für ein Solarmodul gerichtet.

In der Druckschrift EP 2 551 918 A1 ist ein sogenanntes rahmenloses Solarmodul gezeigt. Das rahmenlose flächige Solarmodul wird auf der Rückseite durch zwei parallel zu den Längsseiten verlaufende, voneinander beabstandete Längsstreben gehalten. Mittels dieser Längsstreben wird das Solarmodul auf einer geeigneten Unterkonstruktion gehalten und befestigt welche die Flächenlasten aufnehmen soll.

In der DE 20 2008 013 755 U1 ist ein weiteres flächig ausgebildetes Verstärkungs- oder Stabilisierungselement für ein Photovoltaikmodul beschrieben, bei dem an Stelle eines Rahmens ein mit kegelstumpfförmigen Erhebungen und/oder streifenförmig ausgebildeten Erhebungen versehene Metall- oder Kunststoffplatte auf der Rückseite angeordnet ist. Die Erhebungen sind dabei mit der Rückseite des Solarmoduls flächig verklebt. Problematisch ist bei dieser Lösung allerdings eine Kühlung dieses Solarmoduls, weil die Rückseite nur erheblich eingeschränkt von einem kühlenden Luftstrom umspült und gekühlt werden kann.

In der Druckschrift US 2011/0226335 A1 wird ein Glas-Glas-Solarmodul-Laminat mit innen liegenden Solarzellen mit einem Rahmen offenbart. An dem Solarmodul sind Stützelemente angeordnet, die mit dem Rahmen verbunden sind. Die Verbindungen der Stützelemente erfolgt durch Formschluss mittels einer Schraubverbindung.

Dem vorliegenden Stand der Technik ist es gemeinsam, dass die Durchbiegung zwar mit konstruktiv relativ aufwändigen technischen Lösungen verhindert werden kann, welche aber einer gewünschten möglichen Gewichtsreduzierung eines Solarmoduls entgegenstehen.

Die Aufgabe der Erfindung ist es, ein neuartiges Glas-Glas-Solarmodul-Laminat mit innen liegenden Solarzellen zu schaffen,
- dass auch ein Durchbiegen bei hohen Temperaturen zuverlässig und dauerhaft verhindert,
- dass größere Flächenbelastungen, z. B. durch Nassschnee tragen kann,
- dass möglichst durch Personen betretbar oder begebar ausgebildet ist,
- und es ermöglicht, durch erhebliche Reduzierungen der Glasdicke das Gesamtgewicht solcherart Solarmodule erheblich zu senken, was die Montage vereinfacht und die Flächenlast bei Aufdachsystemen für den Unterbau reduziert.
Auf die Ausbildung von Stützstreben als durchgehende Doppel-T-Profile oder dergleichen, die eine erhöhte Masse besitzen, soll verzichtet werden.

Die Aufgabe wird erfindungsgemäß mit den Merkmalen des ersten Patentanspruches gelöst. Weitere vorteilhafte Ausgestaltungen der Erfindung sind in den rückbezüglichen Unteransprüchen beschrieben. Es wird von einem Glas-Glas-Solarmodul-Laminat 1 mit innen liegenden Solarzellen 2 mit Rahmen 3 ausgegangen, wobei unter dem Glas-Glas-Solarmodul-Laminat 1 mehrere Stützelemente 4, ausgebildet als Stützstreben, angeordnet sind, welche mit dem Rahmen 3 verbunden sind, wobei die Stützelemente (4) mit dem Rahmen mittels elektrisch kontaktierten Schraubverbindungen verbunden ausgebildet sind. Dies verhindert das Durchbiegen bei höheren Temperaturen, ermöglicht größere Flächenbelastungen, wie sie zum Beispiel bei länger aufliegenden und anhaftenden Nassschneelasten auftreten können. Des Weiteren kann ein solches Glas-Glas-Solarmodul-Laminat 1 auch betreten oder falls erforderlich auch begangen werden. Die Verbindung der Stützelemente 4 mit dem außen angeordneten Rahmen 3, wenn dieser elektrisch leitend ausgeführt ist, erfolgt aus Sicherheitsgründen immer auch elektrisch leitend.

Die Durchbiegung eines Glas-Glas-Solaimodul-Laminat 1 kann weitgehend ausgeschlossen werden, wenn erfindungsgemäß die Stützstreben 5 aus besonders biegesteifen legierten Aluminiumprofilen ohne oder mit eloxierter Außenfläche ausgebildet sind. Solche Aluminiumprofile besitzen Rohr- oder Rechteckhohlkammer- Profilquerschnitte. In das jeweilige Ende der jeweiligen Stützstrebe ist ein Mutterteil bis an einen Anschlag straff eingefügt sowie im Mutterteil ein ausgebildeter Schraubkanal für eine selbstschneidende Schraube vorgesehen, welche eine mechanisch feste Verbindung bewirkt.

Insbesondere kann es vorteilhaft sein, wenn bei dem neuartigen Glas-Glas-Solarmodul-Laminat 1 zwischen den Stützelementen 4 oder den Stützstreben 5 zusätzliche kleiner dimensionierte Querversteifungen 6 ausgebildet sind und in Teilbereichen eine Art hinterlegte mechanisch hoch belastbare Gitterstruktur entsteht.

Von wesentlichem Vorteil ist es, wenn zwischen einer Rückseite 8 eines Glas-Glas-Solarmodul-Laminats 1 und einer Vorderseite 9 der Stützelemente 4 oder Stützstreben 5 ganz oder teilflächig ein zusätzliches Zwischenmaterial 10 angeordnet ist, welches weicher als das relativ spröde und harte Glas ausgebildet ist um Brüche und Mikrorisse im Glas zu vermeiden.

Besondere Effekte lassen sich erzielen, wenn das weiche Zwischenmaterial 10 als Kunststoffband oder Kunststoffstreifen ausgebildet ist, welches einseitig oder beidseitig mit einer Klebeschicht beschichtet ist. Das hat den Vorteil, dass das Glas-Glas-Solarmodul-Laminat 1 auf dem Stützelementen 4 bzw. den Stützstreben 5 nicht direkt aufliegt und durch das weiche Material die unterschiedlichen Ausdehnungen zwischen dem Glas-Glas-Solarmodul-Laminat 1 und Stützelementen 4 bzw. den Stützstreben 5 ausgeglichen werden.

Es kann auch für bestimmte Anwendungsfälle sinnvoll sein, dass das Zwischenmaterial 10 als Paste, wie z. B. eine Klebepaste auf Silikonbasis ausgebildet ist, welche zwar später nach der Montage erst aushärtet aber trotzdem so elastisch bleibt, dass die Klebepaste die verschiedenen Ausdehnungen durchaus ausgleichen kann.

Von weiterem erheblichen Vorteil kann es auch sein, wenn die zur Sonne gewandte Oberfläche 7 des Glas-Glas-Solarmodul-Laminats 1 leicht konvex gewölbt ausgebildet ist. Dies wird erreicht, indem die Stützelemente 4 oder die Stützstreben 5 gleichfalls leicht konvex gewölbt ausgebildet sind. Dadurch steht das Glas-Glas-Solarmodul-Laminat 1 in eingebauten Zustand immer unter einer geringen Vorspannung, welche das Durchbiegen zusätzlich weitgehend verhindert.

Durch das neuartige Glas-Glas-Solarmodul-Laminat mit innen liegenden Solarzellen wird das unerwünschte Durchbiegen in der Fläche des Solarmoduls vor allem bei hohen Temperaturen dauerhaft ausgeschlossen. Auch erhebliche Flächenlasten, welche durch anhaftenden und aufliegenden Nassschnee hervorgerufen werden können, sowie in Teilbereichen hohe Drücke eines Fußes können durch die erfindungsgemäße Lösung problemlos ohne Schäden am Glas-Glas-Solarmodul-Laminat 1 aufgenommen werden. Das führt dazu, dass erheblich dünnere Glasscheiben als bisher eingesetzt werden können, was das Gesamtgewicht solcherart Solarmodule merklich senkt. Dadurch lassen sich die Module bei der Montage insgesamt leichter handhaben. Zudem wird nicht nur die Dachlast für die sich darunter befindliche Dachkonstruktion verringert, sondern auch der Unterbau für das Aufdachsystem kann insgesamt leichter und kostengünstiger ausgeführt werden. Als wesentlichster Vorteil der erfindungsgemäßen Lösung ist jedoch die durchgehende Begehbarkeit zum Beispiel für Monteure anzusehen, was sich sehr vorteilhaft bei sehr großflächig belegten Solarmodulflächen auswirkt. Dies führt zu erheblichen Zeit und Kosteneinsparungen beim Dauerbetrieb von großen durchgehend mit photovoltaischen Solarmodulen belegten Flächen.

Weitere Einzelheiten, Merkmale und Vorteile der Erfindung ergeben sich aus der nachfolgenden Beschreibung von Ausführungsbeispielen mit Bezugnahme auf die zugehörigen Zeichnungen. Es zeigen:
- Fig. 1: eine Rückansicht eines neuartigen Glas-Glas-Solarmodul-Laminats 1
- Fig. 2: eine Rückansicht mit zwei Stützstreben 5 und zwei Querversteifungen 6
- Fig. 3: die Seitenansicht A-A durch ein Glas-Glas-Solarmodul-Laminat 1
- Fig. 4: die Einzelheit X aus Fig. 2 im Teilschnitt
- Fig. 5: die Einzelheit Y aus Fig. 3 im Teilschnitt
- Fig. 6: eine Rückansicht mit nur einer Stützstrebe 5
- Fig. 7: die Ansicht A-A aus Fig. 6.
- Fig. 8: die Ansicht B-B aus Fig. 7
- Fig. 9: eine Rückansicht mit zwei Stützstreben 5
- Fig. 10: die Seitenansicht A-A mit zwei Stützstreben gemäß Fig. 9
- Fig. 11: die Einzelheit X mit einer Klebeverbindung 20 zur Befestigung einer Stützstrebe 5

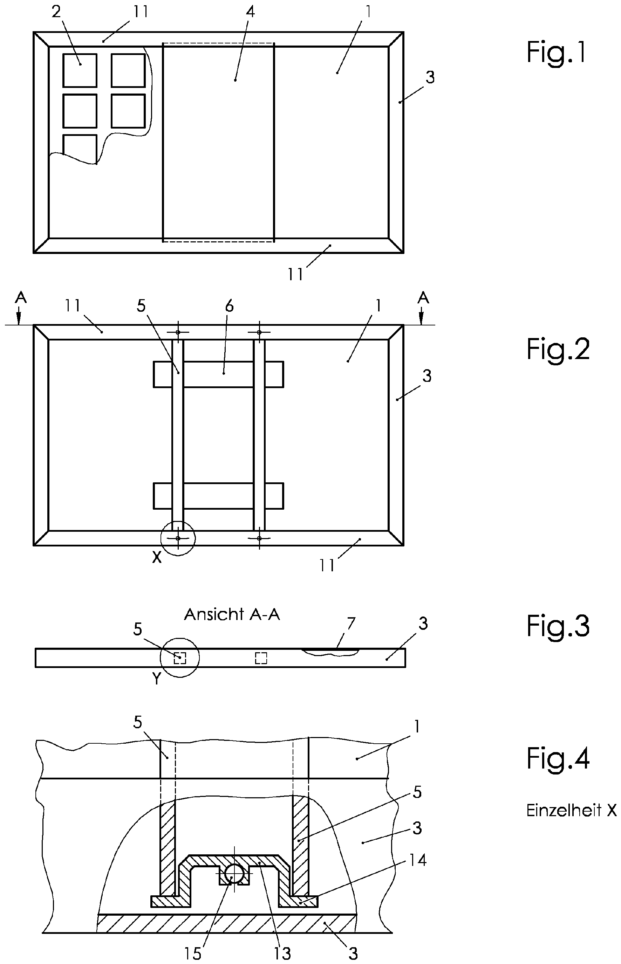

In Figur 1 ist eine Rückansicht eines Solarmoduls mit einem Glas-Glas-Solarmodul-Laminat 1 gezeigt, einschließlich der Anordnung der aktiven eingebetteten Solarzellen 2, einem Rahmen 3 und einem breit ausgeführten Stützelement 4, welches mit den beiden Längsrahmenteilen 11 elektrisch leitend verbunden ist. Das Stützelement kann dabei wahlweise auch durchbrochen als Leichtbauelement ausgeführt sein.

Figur 2 zeigt eine Rückansicht einer möglichen Ausführungsform eines erfindungsgemäßen Solarmoduls mit einem Glas-Glas-Solarmodul-Laminat 1, einem Rahmen 3, mit der Besonderheit dass hier zwei Stützstreben 5 unter der Rückseite angeordnet sind, die mit den beiden Längsrahmenteilen 11 elektrisch leitend verbunden sind, sowie zwei zusätzlich angeordnete Querversteifungen 6, die sich auf den Stützstreben 5 abstützen, wobei die Stützstreben 5 mit den Rahmen 3 verbunden sind. Dadurch werden die auf die Oberfläche des Glas-Glas-Solarmodul-Laminats 1 wirkenden Flächenbelastungen von den Querversteifungen 6 über die Stützstreben 5 auf den Rahmen übertragen bzw. über den Rahmen in die Unterkonstruktion, auf der das Solarmodul befestigt ist, abgeleitet. Die Stützstreben 5 und Querversteifungen 6 wie auch das in Figur 1 gezeigte Stützelement 4 verhindern die Durchbiegung des Glas-Glas-Solarmodul-Laminats 1 bei höheren Temperaturen und ermöglichen die Tragfähigkeit hoher Schneelasten, wobei die Querverbindungen 6 im darüber befindlichen Bereich auch relativ hohe, flächenmäßig klein auftretende, Flächenbelastungen (hervorgerufen z.B. durch eine Person) ohne Beschädigung des Solarmodul-Laminats aufnehmen können. Dadurch wird die Begehbarkeit einer Solarmodulfläche möglich.

In Figur 3 ist die Ansicht A-A aus Figur 2 abgebildet, welches die Anordnung und Dimensionierungsverhältnisse der Stützstreben 5 gegenüber dem Rahmen 3 beim Glas-Glas-Solarmodul-Laminat 1 verdeutlicht.

Figur 4 zeigt die Einzelheit X aus Fig. 2 in einer Teilschnittdarstellung. Hier ist eine mögliche bevorzugte feste Verbindung der Stützstrebe 5 mit dem Rahmen 3 aufgezeigt. In das Ende der Stützstrebe 5 ist ein Mutterteil 13 bis an einen Anschlag 14 straff eingefügt. Im Mutterteil 13 befindet sich ein ausgebildeter Schraubkanal für eine selbstschneidende Schraube 15 welche eine mechanisch feste Verbindung bewirkt.

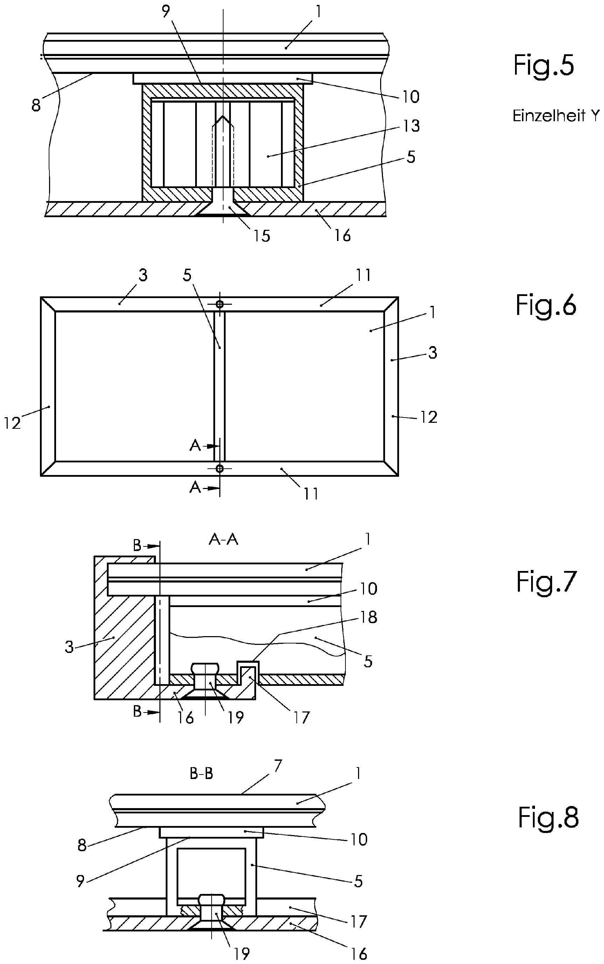

Figur 5 zeigt die Einzelheit Y aus Fig. 3 im Schnitt. Die Schraube 15 verbindet über einen Rahmenschenkel 16 mit der Stützstrebe 5 mittels des Mutterteils 13 mechanisch und elektrisch. Zwischen der Vorderseite 9 der Stützstrebe 5 und der Rückseite 8 des Glas-Glas-Solarmodul-Laminates 1 befindet sich ein zusätzliches Zwischenmaterial 10, hier in einer Ausführung eines nur einseitig klebenden Kunststoffbandes.

In Figur 6 ist die Rückansicht eines Solarmoduls mit dem Glas-Glas-Solarmodul-Laminat 1 gezeigt, wobei zwischen den zwei Längsrahmenteilen 11 des Rahmens 3 nur eine einzige Stützstrebe 5 angeordnet und mechanisch fest verbunden ist.

Aus der Figur 7, welche die Ansicht A-A aus Figur 6 darstellt, ist eine andere Befestigung der Stützstrebe 5 mittels eines am Rahmen 3 zusätzlich angebrachten Rahmenschenkels 16 und einer Rahmenschenkelrippe 17 gezeigt. In diesem Befestigungsfall ist in einer rechteckförmig als Holprofil ausgeführten Stützstrebe 5 eine Nut 18 ausgespart, in welche die Rahmenschenkelrippe 17 eingreift. Ein relativ einfacher Blindniet 19 verbindet diese spezielle Stützstrebe 5 mit dem Rahmenschenkel 16 mechanisch so fest, dass die über die Stützstrebe 5 eingeleiteten Kräfte trotzdem ausreichend und zuverlässig in den Rahmen 3 abgeleitet werden können. Das Einfügen der Stützstrebe 5 in den Rahmen 3 erfolgt nach Montage der beiden Längsrahmenteile 11 am Glas-Glas-Solarmodul-Laminat 1 und vor Montage der beiden Querrahmenteile 12.

Figur 8 zeigt die Ansicht B-B in der Ausfuhrung der Befestigung gemäß Figur 7. Der Blindniet 19 verbindet den Rahmenschenkel 16 mit der Stützstrebe 5 mechanisch und elektrisch. Zwischen der Vorderseite 9 der Stützstrebe 5 und der Rückseite 8 des Laminats befindet sich ein Zwischenmaterial 10 in Form eines einseitig klebenden Kunststoffbandes, welches die unterschiedliche Ausdehnungen des Glas-Glas-Solarmodul-Laminats 1, der Stützstreben 5 und des Rahmens 3 ermöglicht.

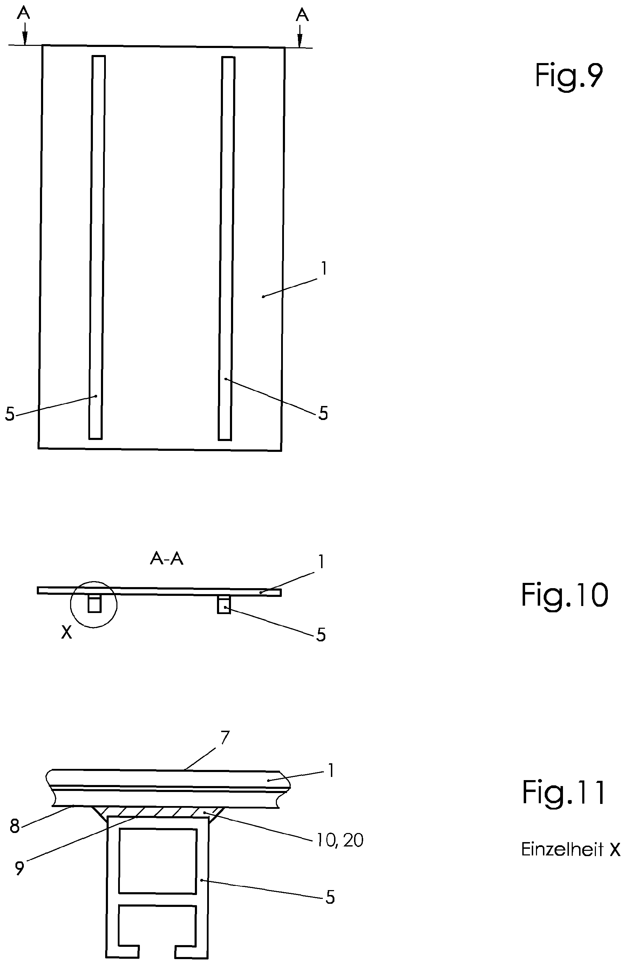

Figur 9 zeigt die Rückansicht eines Solarmoduls mit Glas-Glas-Solarmodul-Laminat 1 ohne Rahmen mit zwei Stützstreben 5.

Figur 10 zeigt die Ansicht A-A als Seitenansicht aus Figur 9 mit einem Glas-Glas-Solarmodul-Laminat 1 und zwei angeordneten Stützstreben 5.

In Figur 11 ist die Einzelheit X aus Figur 10 als Schnitt gezeigt. Die Rückseite 8 des Glas-Glas-Solarmodul-Laminats 1 ist über die Klebeverbindung 20, welche das weiche und elastische Zwischenmaterial 10 bildet, fest mit der Vorderseite 9 der Stützstrebe 5 verbunden.

Das erfindungsgemäße Glas-Glas-Solarmodul-Laminat ist bevorzugt für großflächig und durchgehend mit photovoltaischen Solarmodulen belegte Flächen geeignet, welche unterschiedlich steil verlegt sein können. Es verringert insgesamt die Dachlast erheblich und ist bei weniger steil geneigten Installationen trotzdem zur Begehbarkeit geeignet, obwohl das Glas-Glas-Solarmodul-Laminat 1 insgesamt erheblich dünner ausgeführt ist. Dies führt zu erheblichen Kosteneinsparung für den Einsatz und den Betrieb von photovoltaischen Solarmodulen.

### Bezugszeichenliste

- 1: Glas-Glas-Solarmodul-Laminat
- 2: Solarzellen
- 3: Rahmen
- 4: Stützelement
- 5: Stützstrebe
- 6: Querversteifung
- 7: Oberfläche des Glas-Glas-Solarmodul-Laminats
- 8: Rückseite des Glas-Glas-Solarmodul-Laminats
- 9: Vorderseite des Stützelements oder der Stützstrebe
- 10: Zwischenmaterial
- 11: Längsrahmenteil
- 12: Querrahmenteil
- 13: Mutterteil
- 14: Anschlag Mutterteil
- 15: Schraube
- 16: Rahmenschenkel
- 17: Rahmenschenkelrippe
- 18: Nut
- 19: Blindniet
- 20: Klebeverbindung

## Patentansprüche

1. Glas-Glas-Solarmodul-Laminat (1) mit innen liegenden Solarzellen (2) mit Rahmen (3), wobei unter dem Glas-Glas-Solarmodul-Laminat (1) mehrere Stützelemente (4), ausgebildet als Stützstreben (5), angeordnet sind, welche mit dem Rahmen (3) verbunden sind, wobei die Stützelemente (4) mit dem Rahmen (3) mittels elektrisch kontaktierten Schraubverbindungen verbunden ausgebildet sind,
**dadurch gekennzeichnet, dass**
die Stützstreben (5) aus legiertem Aluminium ohne oder mit eloxierter Außenfläche bestehen und im Querschnitt als Rohr- oder Rechteckhohlkammer-Profil ausgebildet sind, wobei in das jeweilige Ende der jeweiligen Stützstrebe (5) ein Mutterteil (13) bis an einen Anschlag (14) straff eingefügt ist sowie im Mutterteil (13) ein ausgebildeter Schraubkanal (15) für eine selbstschneidende Schraube vorgesehen ist, welche eine mechanisch feste Verbindung bewirkt.

2. Glas-Glas-Solarmodul-Laminat (1) nach Aspruch 1,
**dadurch gekennzeichnet, dass**
zwischen den Stützelementen (4) oder den Stützstreben (5) zusätzliche kleiner dimensionierte Querversteifungen (6) ausgebildet sind.

3. Glas-Glas-Solarmodul-Laminat (1) nach einem der vorstehenden Ansprüche,
**dadurch gekennzeichnet, dass**
zwischen einer Rückseite (8) des Glas-Glas-Solarmodul-Laminats (1) und einer Vorderseite (9) der Stützelemente (4) oder Stützstreben (5) ganz- oder teilflächig ein Zwischenmaterial (10) angeordnet ist, welches weicher als Glas ausgebildet ist.

4. Glas-Glas-Solarmodul-Laminat (1) nach Anspruch 3,
**dadurch gekennzeichnet, dass**
das Zwischenmaterial (10) als ein Kunststoffband oder ein Kunststoffstreifen ausgebildet ist, welches einseitig oder beidseitig mit einer Klebeschicht beschichtet ist.

5. Glas-Glas-Solarmodul-Laminat (1) nach Anspruch 3,
**dadurch gekennzeichnet, dass**
das Zwischenmaterial (10) als eine Paste auf Silikonbasis ausgebildet ist, welche später aushärtet.

6. Glas-Glas-Solarmodul-Laminat (1) nach einem der vorstehenden Ansprüche,
**dadurch gekennzeichnet, dass**
die Stützelemente (4) oder die Stützstreben (5) so gewölbt sind, das die zur Sonne gewande Oberfläche (7) des Glas-Glas-Solarmodul-Laminats (1) leicht konvex gewölbt ausgebildet ist.

## Claims

1. A glass-glass solar module laminate (1) with internal solar cells (2) having a frame (3), wherein, below the glass-glass solar module laminate (1), a plurality of supporting elements (4) formed as supporting struts (5) are arranged which are connected to the frame (3), wherein the supporting elements (4) are designed to be connected to the frame (3) by means of electrically contacted screw connections,
**characterized in that**
the supporting struts (5) are made of alloyed aluminum with or without anodized outer surface and are formed in cross-section as a tube profile or rectangular hollow chamber profile, wherein a female part (13) is rigidly inserted into the respective end of the respective supporting strut (5) up to a stop (14), and in the female part (13), a formed screw channel (15) for a self-tapping screw being provided, which ensures a mechanically fixed connection.

2. The glass-glass solar module laminate (1) according to claim 1,
**characterized in that**,
between the supporting elements (4) or the supporting struts (5), additional cross-bracings (6) of smaller dimensions are formed.

3. The glass-glass solar module laminate (1) according to any one of the preceding claims,
**characterized in that**,
between a rear side (8) of the glass-glass solar module laminate (1) and a front side (9) of the supporting elements (4) or supporting struts (5), an intermediate material (10) is arranged over the entire surface or a partial surface, which is formed to be softer than glass.

4. The glass-glass solar module laminate (1) according to claim 3,
**characterized in that**
the intermediate material (10) is formed as a plastic strap or plastic strip coated with an adhesive layer on one side or both sides.

5. The glass-glass solar module laminate (1) according to claim 3,
**characterized in that**
the intermediate material (10) is formed as a silicone-based paste which cures later.

6. The glass-glass solar module laminate (1) according to any one of the preceding claims,
**characterized in that**
the supporting elements (4) or the supporting struts (5) are curved such that the upper surface (7) of the glass-glass solar module laminate (1) facing the sun is formed to be slightly convex-shaped.

## Revendications

1. Module solaire en stratifié verre-sur-verre (1) comportant des cellules solaires (2) situées à l'intérieur et pourvues d'un cadre (3), dans lequel plusieurs éléments de soutien (4) réalisés sous forme d'entretoises de soutien (5) sont agencés au-dessous du module solaire en stratifié verre-sur-verre et sont reliés au cadre (3), et les éléments de soutien (4) sont réalisés en étant reliés au cadre (3) au moyen de liaisons vissées avec mise en contact électrique,
**caractérisé en ce que**
les entretoises de soutien (5) sont constituées en aluminium allié pourvu ou dépourvu d'une surface extérieure anodisée et sont réalisées en section transversale sous forme de profil tubulaire ou profil à chambre creuse rectangulaire, un élément formant écrou (13) étant inséré de façon serrée dans l'extrémité respective de l'entretoise de soutien respective (5) jusqu'à une butée (14), et un canal de vissage (15) réalisé dans l'élément formant écrou (13) étant prévu pour une vis auto-taraudeuse qui assure une liaison mécaniquement ferme.

2. Module solaire en stratifié verre-sur-verre (1) selon la revendication 1,
**caractérisé en ce que**
des rigidifications transversales (6) supplémentaires de dimensions plus petites sont réalisées entre les éléments de soutien (4) ou entre les entretoises de soutien (5).

3. Module solaire en stratifié verre-sur-verre (1) selon l'une des revendications précédentes,
**caractérisé en ce que**
un matériau intermédiaire (10) est agencé sur toute la surface ou sur une partie entre une face arrière (8) du module solaire en stratifié verre-sur-verre (1) et une face avant (9) des éléments de soutien (4) ou des entretoises de soutien (5), matériau qui est plus souple que le verre.

4. Module solaire en stratifié verre-sur-verre (1) selon la revendication 3,
**caractérisé en ce que**
le matériau intermédiaire (10) est réalisé sous la forme d'une bande en matière plastique ou d'un ruban en matière plastique qui est revêtu(e) unilatéralement ou bilatéralement d'une couche de colle.

5. Module solaire en stratifié verre-sur-verre (1) selon la revendication 3,
**caractérisé en ce que**
le matériau intermédiaire (10) est réalisé sous forme de pâte à base de silicone qui durcit ultérieurement.

6. Module solaire en stratifié verre-sur-verre (1) selon l'une des revendications précédentes,
**caractérisé en ce que**
les éléments de soutien (4) ou les entretoises de soutien (5) sont bombé(e)s de telle sorte que la surface (7) tournée vers le soleil du module solaire en stratifié verre-sur-verre (1) est réalisée de façon bombée légèrement convexe.
